Europäisches Patentamt

**European Patent Office**

**Office européen des brevets**

(19)

(11) Numéro de publication: **0 204 387**
**B1**

(12) # FASCICULE DE BREVET EUROPÉEN

(45) Date de publication du fascicule du brevet:
28.02.90

(51) Int. Cl.⁵: **H 01 L 27/06**

(21) Numéro de dépôt: **86200982.6**

(22) Date de dépôt: **05.06.86**

(54) **Dispositif semiconducteur pour la réalisation des capacités de découplage placées entre l'alimentation et la masse des circuits intégrés.**

(30) Priorité: **07.06.85 FR 8508633**

(43) Date de publication de la demande:
**10.12.86 Bulletin 86/50**

(45) Mention de la délivrance du brevet:
**28.02.90 Bulletin 90/09**

(84) Etats contractants désignés:
**DE FR GB NL**

(56) Documents cité:

RCA REVIEW, vol. 42, no. 4, décembre 1981, pages 522-541, Princeton, N.J., US; L. CHAINULU UPADHYAYULA et al.: "GaAs integrated circuit development for gigabit-rate signal processing"

PROCEEDINGS OF THE IEEE, vol. 70, no. 1, janvier 1982, pages 35-45, IEEE, New York, US; S.I. LONG et al.: "High speed GaAs integrated circuits"

PATENTS ABSTRACTS OF JAPAN, vol. 8, no. 231 (E-274) 1668 , 24 octobre 1984; & JP - A - 59 112 645 (FUJITSU K.K.) 29-06-1984

IEEE ELECTRON DEVICE LETTERS, vol. EDL-3, no. 10, octobre 1982, pages 284,285, IEEE, New York, US; A.W. LIVINGSTONE et al.: "Manufacturing tolerance of capacitor coupled GaAs FET logic circuits"

(73) Titulaire: **LABORATOIRES D'ELECTRONIQUE PHILIPS**
**3, Avenue Descartes**
**F-94450 Limeil-Brévannes (FR)**
(84) Etats contractants désignés: **FR**

(73) Titulaire: **N.V. Philips' Gloeilampenfabrieken**
**Groenewoudseweg 1**
**NL-5621 BA Eindhoven (NL)**
(84) Etats contractants désignés: **DE GB NL**

(72) Inventeur: **Meignant, Didier Serge**
**Société Civile S.P.I.D. 209 rue de l'Université**
**F-75007 Paris (FR)**

(74) Mandataire: **Landousy, Christian**
**Société Civile S.P.I.D. 209, Rue de l'Université**
**F-75007 Paris (FR)**

LIBERGRAF, STOCKHOLM 1990

EP 0 204 387 B1

**Description**

L'invention concerne un dispositif semiconducteur, incluant au moins un transistor à effet de champ monolithiquement intégré sur un substrat avec une diode formant un élément capacitif, ce transistor comprenant des contacts de source et de drain de type ohmique réalisés sur une première couche semiconductrice de type N formée en surface du substrat, et entre les contacts de source et de drain une électrode de grille formant une jonction redresseuse avec ladite première couche semiconductrice, ladite diode comprenant un contact de type Schottky réalisé sur une seconde couche semiconductrice de type N, également formée en surface du substrat.

L'invention trouve son application dans la réalisation des capacités de découplage placées entre l'alimentation continue et la masse, dans des circuits intégrés en arséniure de gallium par exemple.

Une diode Schottky formant un élément capacitif monolithiquement intégré avec un transistor à effet de champ en arséniure de gallium est connue de l'art antérieur par le brevet japonais 59-112 645 (A) de 1984. Ce document décrit une diode formée par une première couche de type-N réalisée sur un substrat semi-isolant en arséniure de gallium, cette couche portant un contact Schottky et étant adjacente à une première couche de type $N^+$. Le transistor monolithiquement intégré avec cette diode comprend un contact de grille de type Schottky réalisé en surface d'une seconde couche de type N adjacente d'une part à la première couche $N^+$ et d'autre part à une seconde couche type $N^+$ qui porte le contact de drain de type ohmique.

Ainsi réalisée, cette structure devrait constituer l'association entre un transistor à effet de champ à grille Schottky, et une diode, faisant fonction de capacité, dont la cathode est commune avec la source du transistor. Il faut noter que le contact commun de source et de cathode n'est pas concrétisé par la réalisation d'une couche ohmique en surface de la première couche N.

Or dans le but d'éviter la génération de bruits de commutation dans les circuits intégrés, il est impératif de prévoir une capacité de découplage placée entre l'alimentation continue de ces circuits et la masse. Si le circuit intégré est à transitions lentes (< 50 ps) cette capacité peut être externe au circuit et reliée à l'alimentation continue et à la masse par des fils fins. Mais si le circuit intégré est à transitions rapides (> 50 ps) l'impédance des fils de thermocompression, qui est alors très élevée, nuit à l'efficacité du découplage par une capacité extérieure ainsi reliée.

C'est pourquoi, surtout pour l'application envisagée aux circuits intégrés sur semiconducteurs du groupe III - V qui permettent des transitions extrêmement rapides, la capacité de découplage de l'alimentation continue doit être intégrée avec le micro-circuit afin de supprimer les fils de thermo-compression.

Le but de la présente invention est donc de résoudre ce problème. Selon l'invention, la solution est fournie par un dispositif semiconducteur tel que décrit dans le préambule, caractérisé en ce qu'il inclut au moins une ligne d'alimentation continue et au moins une ligne de masse également intégrée sur ledit substrat, en ce que la ligne d'alimentation continue est reliée de façon ohmique à la seconde couche semiconductrice alors que la ligne de masse forme un contact Schottky de grande surface avec la seconde couche semiconductrice et constitue ainsi cette diode présentant ainsi une capacité de grande valeur réalisant le dicouplage entre l'alimentation et la masse des circuits intégrais.

Selon la présente invention, le découplage permettant d'éviter les bruits de commutation est donc réalisé sans éléments extérieur au circuit, sans augmenter la surface de ce dernier, et de très grandes vitesses de fonctionnement ou bien un fonctionnement en hyperfréquences peuvent être obtenu avec un dispositif de réalisation particulièrement simple.

L'invention sera mieux comprise à l'aide de la description suivante, illustrée par les figures annexées dont:

- la figure 1 qui représente le schéma électrique du dispositif selon l'invention;
- la figure 2 qui représente en coupe une mise en oeuvre de l'invention selon ce schéma électrique;
- la figure 3 qui représente le schéma électrique d'un dispositif particulier conforme à l'invention;
- la figure 4 qui représente en coupe la mise en oeuvre de l'invention selon ce schéma électrique particulier.

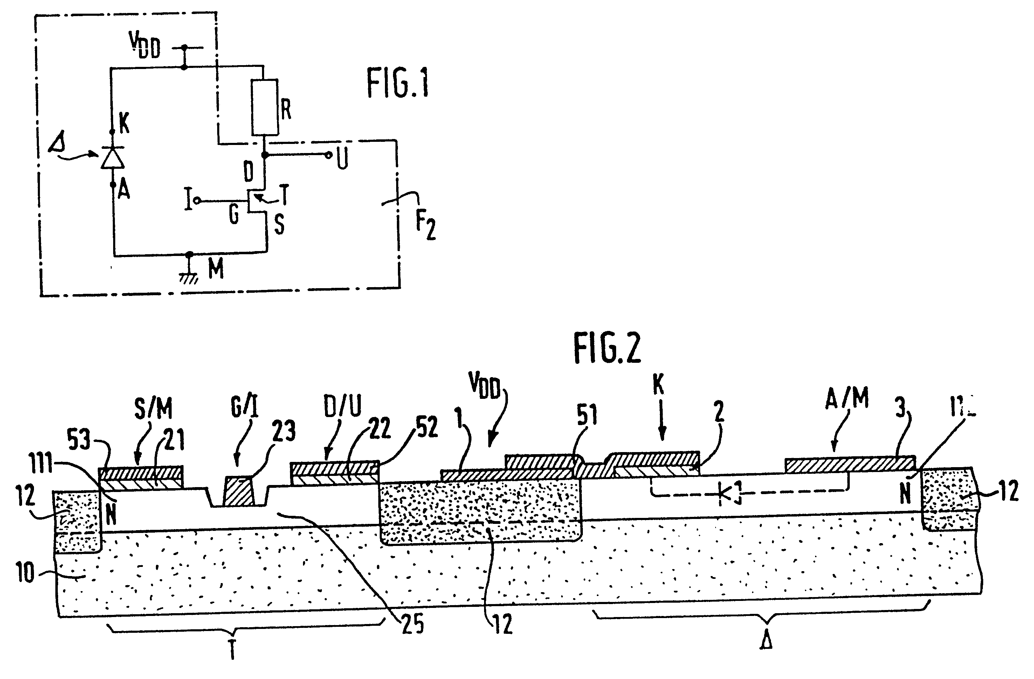

Tel que représenté schématiquement sur la figure 1, le dispositif selon l'invention comprend un transistor à effet de champ T, dont le drain D est relié à l'alimentation continue $V_{DD}$ à travers une charge R. Ce transistor comporte une grille G et une source S qui peut être par exemple reliée à la masse M.

L'alimentation continue $V_{DD}$ est découplée par rapport à la masse M par une diode $\Delta$ dont la cathode K est reliée à l'alimentation $V_{DD}$ alors que l'autre électrode, l'anode A est reliée à la masse.

La grille G du transistor à effet de champ T peut recevoir par exemple un signal d'entrée I, et le signal de sortie U du dispositif est alors disponible sur le drain D.

Ce dispositif peut être monolithiquement intégré sur une plaquette de semiconducteur, comme il est représenté sur la figure 2. Dans un exemple de réalisation le semiconducteur peut être l'arséniure de gallium, matériau du groupe III - V, dont les propriétés permettent de réaliser des circuits soit ultrarapides, soit fonctionnant en hyperfréquences.

Tel que représenté sur la figure 2, le dispositif selon l'invention comprend un substrat semi-iso-

lant 10 en un matériau du groupe III - V en surface duquel sont réalisées une première couche de type N 111 et une seconde couche de type N 112, ces couches présentant un paramètre de maille compatible avec le substrat. Ces couches sont limitées d'une part, et séparées l'une de l'autre d'autre part, par des zones semi-isolantes 12.

Le transistor à effet de champ T est formé de la première couche N 111, du contact ohmique 21 de source S, du contact ohmique 22 de drain D et du contact Schottky 23 de grille G éventuellement réalisé dans une zone amincie 25 de la couche 111, formant dans ce cas un transistor à effet de champ dit à canal creusé.

La source S et le drain D peuvent être épaissis par des couches métalliques respectivement 53 et 52, dites secondes couches d'interconnexion, qui relient respectivement la source S par exemple à la masse M et le drain D à la charge R, non représentée ici, la figure 2 correspondant à la partie F₂ de la figure 1 délimitée par un trait discontinu.

La diode Δ est formée de la seconde couche N 112, du contact ohmique 2 formant la cathode K, du contact Schottky 3 formant l'anode A. Sur la zone 12 semi-isolante qui sépare les couches N 111 et 112 peut être réalisée par exemple une ligne d'alimentation continue $V_{DD}$. La cathode K de la diode est reliée alors à cette ligne par une couche métallique 51 de seconde couche d'interconnexion.

En ce qui concerne par ailleurs l'anode A, elle est prévue pour coïncider avec une ligne de masse de grande surface. Ainsi réalisée la diode Δ, lors du fonctionnement du micro-circuit, est polarisée en inverse. Elle constitue une capacité de valeur:

$$C = \varepsilon\, S/W$$

où t est la permitivité

W est l'épaisseur de la zone désertée sous le contact Schottky 3 formant l'anode A et S est la surface de ce contact Schottky.

La tension d'alimentation continue $V_{DD}$ est choisie inférieure à la tension de désertion de la couche N 112, ce qui est facilement réalisable sans diminuer les performances du transistor T en prévoyant de réaliser le contact de grille de ce dernier dans la zone amincie 25 de la couche N 111 comme il a été dit précédemment.

Dans ces conditions, comme la ligne de masse présente une grande surface S, ce qui est d'ailleurs avantageux pour le circuit, la capacité C ainsi formée est de grande valeur.

Dans l'exemple de réalisation où le matériau constituant le substrat et les couches N, est l'arséniure de gallium (GaAs), la tension d'alimentation continue $V_{DD}$ est de l'ordre de 1,2 V, et la capacité est de l'ordre de $10^{-15}F/\mu m^2$.

Pour une ligne de masse présentant une surface:

$$S \simeq 10.000\ \mu m^2$$
alors $\qquad C \simeq 10\ pF = 10^{-11}\ F$
l'impédance $\quad Z = 1/C\omega$ où $\omega = 2\pi f$, f étant la

fréquence de fonctionnement qui peut atteindre 10 GHz, correspondant à des transitions de l'ordre de 50 ps

$$f = 10.10^9\ Hz.$$

Alors

$$Z = 1/10^{-11} \times 2\pi \times 10.^{19} \simeq 10/2\pi\ 1,5\ \Omega$$

Un tel résultat est extrêmement avantageux si on le compare avec les résultats qui seraient obtenus si l'on réalisait le découplage par une capacité extérieure au circuit et reliée à l'alimentation continue et à la masse par des fils fins. Dans le cas des transitions rapides de l'ordre de 50 ps envisagées, la self-inductance L des fils fins de raccord est de l'ordre de 1nH par mm. Pour une fréquence correspondante de 10 GHz, l'impédance est alors Z' telle que:

$$L = 10^{-9}\ H \qquad\qquad f = 10.10^9\ Hz$$
$$Z' = L$$
$$Z' = 1.10^{-9} \times 2\pi \times 10.10^9 \simeq 60\ \Omega$$

On note donc que l'impédance $Z \simeq 1,5\ \Omega$ obtenue dans le cas de l'invention est extrêmement petite devant l'impédance $Z' \simeq 60\ \Omega$ obtenue seulement pour les fils de liaison dans le cas d'utilisation d'une capacité extérieure. Ce calcul montre bien qu'il est impossible d'utiliser une capacité extérieure aux fréquences supérieurs ou égales à 10 GHz.

En revanche la capacité formée selon l'invention est d'une grande utilité.

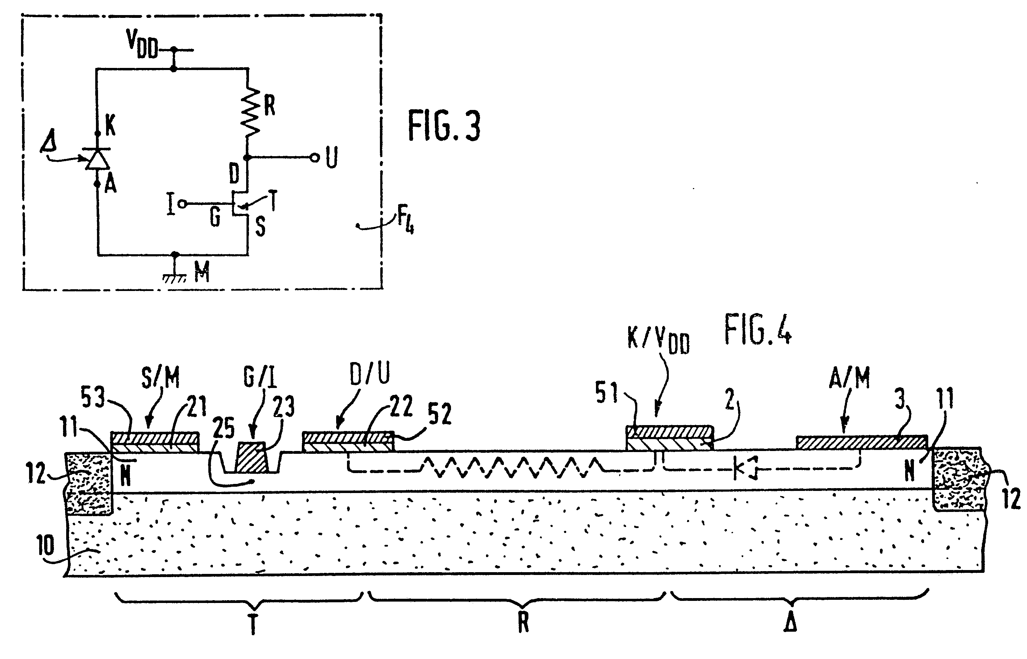

Dans un autre exemple de réalisation représenté schématiquement figure 3, la charge R du transistor T est de type résistif. Une mise en oeuvre avantageuse de l'invention est alors représentée en coupe figure 4, correspondant à l'ensemble du circuit F₄ délimité par un trait discontinu sur la figure 3.

Tel que représenté sur cette figure 4, le dispositif comprend une seule couche N 11, réalisée en surface du substrat semi-isolant 10 et limitée par les zones semi-isolantes 12. Le transistor T, la résistance R et la diode Δ sont réalisés dans cette même couche N 11.

Le transistor T comprend, comme dans l'exemple précédent illustré par la figure 2, un contact ohmique 21 de source S relié par une métallisation 53 de seconde couche d'interconnexion à la masse M, un contact de grille G de type Schottky 23 éventuellement réalisé dans une zone amincie 25 de la couche N et un contact de drain D de type ohmique 22 par exemple recouvert d'une métallisation 52 de seconde couche d'interconnexion. La grille G peut alors recevoir un signal d'entrée I, un signal de sortie U étant disponible sur le drain.

La résistance R est réalisée entre le contact ohmique de drain 22 et un second contact ohmique 2, lequel constitue en outre la cathode K de la diode Δ. Le contact 2 est couvert par une seconde couche d'interconnexion 51 qui permet sa liaison à l'alimentation continue V<sub>DD</sub>. La diode comprend enfin, de même que précédemment un contact Schottky 3 constituant à la fois l'anode A et la ligne de masse M de grande surface.

Le fonctionnement et les performances du circuit sont identiques à ceux de l'exemple précédent illustré par la figure 2. Cependant le dispositif selon l'invention illustré par la figure 4 est d'une mise en oeuvre particulièrement aisée et avantageuse.

Dans le cas où le dispositif semiconducteur est réalisé en arséniure de gallium (GaAs) les contacts ohmiques peuvent être réalisés en un alliage or-germanium (Au-Ge = 40/60) et les contacts de type Schottky ainsi que les métallisations de seconde couche d'interconnexion ou de ligne d'alimentation V<sub>DD</sub> sur zone semi-isolante peuvent être constituées d'une superposition de couches titane-platine-or (Ti-Pt-Au) ou titane-platine-nickel (Ti-Pt-Ni). La couche ou les couches de type N et les zones semi-isolantes peuvent être obtenues par de nombreuses méthodes telles que la croissance épitaxiale associée à l'implantation ionique par exemple, ou l'implantation ionique seule, toutes méthodes connues de l'homme de l'art et ne faisant pas à proprement parler partie de l'invention.

C'est pourquoi il est évident que de nombreuses variantes peuvent être imaginées sans pour autant sortir du cadre de l'invention tel que défini par les revendications ci-après annexées.

**Revendications**

1. Dispositif semiconducteur incluant au moins un transistor à effet de champ monolithiquement intégré sur un substrat (10) avec une diode formant un élément capacitif, ce transistor comprenant des contacts de source (53) et de drain (52) de type ohmique réalisés sur une première couche semiconductrice (111) de type N formée en surface du substrat (10), et entre les contacts de source et de drain une électrode de grille (23) formant une jonction redresseuse avec ladite première couche semiconductrice, ladite diode comprenant un contact de type Schottky réalisé sur une seconde couche semiconductrice (112) de type N, également formée en surface du substrat, caractérisé en ce qu'il inclut au moins une ligne d'alimentation continue (1) et au moins une ligne de masse (3) également intégrée sur ledit substrat, en ce que la ligne d'alimentation continue est reliée de façon ohmique à la seconde couche semiconductrice (112) alors que la ligne de masse forme un contact Schottky de grande surface avec la seconde couche semiconductrice et constituent ainsi cette diode présentant ainsi capacité de grande valeur réalisant le découplage entre l'alimentation et la masse de circuit intégrés.

2. Dispositif semiconducteur selon la revendication 1, caractérisé en ce que les couches semiconductrices sont en un matériau d'un groupe III - V.

3. Dispositif semiconducteur selon la revendication 2, caractérisé en ce que les couches semiconductrices sont en arséniure de gallium.

4. Dispositif semiconducteur selon l'une des revendications 1 à 3, caractérisé en ce que la première couche N et la seconde couche N sont séparées par une zone semi-isolante (12).

5. Dispositif semiconducteur selon l'une des revendications 1 à 3, caractérisé en ce que la première couche N et la seconde couche N font parties d'une même couche semiconductrice cohérente (11).

6. Dispositif semiconducteur selon l'une des revendications 1 à 5, caractérisé en ce que le transistor à effet de champ est à charge résistive, charge qui est formée dans une prolongation de la première couche de type N, et en ce que les contacts d'extrémités de cette résistance sont d'une part le contact ohmique (22) de drain du transistor et d'autre part un second contact ohmique (2) réalisé également en surface de cette première couche N et relié à la ligne d'alimentation.

7. Dispositif semiconducteur selon la revendication 6, caractérisé en ce que la ligne d'alimentation continue est formée par une couche métallique en surface de la zone semi-isolante et reliée à la seconde couche semiconductrice et au second contact ohmique de la résistance de charge par une couche métallique superposée dite seconde couche d'interconnexion.

8. Dispositif semiconducteur selon l'une des revendications 1 à 7 caractérisé en ce que l'électrode de grille (23) forme un contact Schottky, avec la première couche semiconductrice.

9. Dispositif semiconducteur selon la revendication 8, caractérisé en ce que le transistor à effet de champ est du type dit à canal creusé (25).

10. Dispositif semiconducteur selon l'une des revendications 1 à 9, caractérisé en ce que le substrat (10) est en arséniure de gallium semi-isolant.

**Patentansprüche**

1. Halbleiteranordnung mit mindestens einem Feldeffekttransistor, der auf einem Träger (10) mit einer Diode monolithisch integriert ist, und dadurch ein kapazitives Element bildet, wobei dieser Transistor einen ohmschen Source- und Drain-Kontakt, (53) bzw. (52) aufweist, die auf einer auf der Oberfläche des Trägers (10) gebildeten ersten N-leitenden Halbleiterschicht vorgesehen sind, und wobei zwischen dem Source- und Drain-Kontakt eine Gate-Elektrode (23) mit der genannten ersten Halbleiterschicht einen Gleichrichterübergang bildet, wobei diese Diode einen auf einer zweiten N-leitenden Halbleiterschicht (112) vorgesehenen Schottky-Kontakt aufweist, der ebenfalls auf der Oberfläche des Trägers gebildet ist, dadurch gekennzeichnet, daß die Anordnung mindestens eine Gleichspannungsspeiseleitung (1) und mindestens eine ebenfalls auf dem genannten Träger integrierte Massenleitung (3) aufweist, daß die Gleichspannungsspeiseleitung auf ohmsche Weise auf der zweiten Halbleiterschicht (112) ausgebildet ist, während die Massenleitung einen Schottky-Kontakt großer Oberfläche mit der zweiten Halbleiterschicht und ebenfalls diese Diode bildet, die ebenfalls einen großen Kapazitätswert bildet, wodurch die Entkopplung zwischen der Speisung und der Masse der integrierten Schaltung verwirklicht wird.

2. Halbleiteranordnung nach Anspruch 1, dadurch gekennzeichnet, daß die Halbleiterschichten aus einem Werkstoff einer Gruppe III - V besteht.

3. Halbleiteranordnung nach Anspruch 2, dadurch gekennzeichnet, daß die Halbleiterschichten aus Galliumarsenid bestehen.

4. Halbleiteranordnung nach einem der Ansprüche 1 bis 3, dadurch gekennzeichnet, daß die erste N-leitende Schicht und die zweite N-leitende Schicht durch eine halbisolierende Zone (12) voneinander getrennt sind.

5. Halbleiteranordnung nach einem der Ansprüche 1 bis 3, dadurch gekennzeichnet, daß die erste N-leitende Schicht und die zweite N-leitende Schicht je einen Teil ein und derselben kohärenten Halbleiterschicht (11) bilden.

6. Halbleiteranordnung nach einem der Ansprüche 1 bis 5, dadurch gekennzeichnet, daß der Feldeffekttransistor eine spezifische Widerstandsladung aufweist, die in einer Fortsetzung der ersten N-leitenden Schicht gebildet ist, und daß die Anschlußkontakte dieses Widerstandes einerseits der ohmsche Drain-Kontakt (22) des Transistors un andererseits ein zweiter ohmscher Kontakt (2) sind, der ebenfalls auf der Oberfläche der ersten N-leitenden Schicht vorgesehen und mit der Speiseleitung verbunden ist.

7. Halbleiteranordnung nach Anspruch 6, dadurch gekennzeichnet, daß die Gleichspannungsspeiseleitung durch eine metallische Schicht auf der Oberfläche der halbisolierenden Zone gebildet und mittels einer als zweite Verbindungsschicht bezeichneten überlagerten metallischen Schicht mit der zweiten Halbleiterschicht sowie dem zweiten ohmschen Kontakt der Widerstandsladung verbunden ist.

8. Halbleiteranordnung nach einem der Ansprüche 1 bis 7, dadurch gekennzeichnet, daß die Gate-Elektrode (23) mit der ersten Halbleiterschicht einen Schottky-Kontakt bildet.

9. Halbleiteranordnung nach Anspruch 8, dadurch gekennzeichnet, daß der Feldeffekttransistor vom vertieften Kanaltyp (25) ist.

10. Halbleiteranordnung nach einem der Ansprüche 1 bis 9, dadurch gekennzeichnet, daß der Träger (10) aus halbisolierendem Galliumarsenid besteht.

## Claims

1. A semiconductor device comprising at least one field effect transistor integrated monolithically on a substrate (10) with a diode forming a capacitive element, this transistor having ohmic source (53) and drain (52) contacts provided on a first n-type semiconductor layer (111) formed at the surface of the substrate (10), while a gate electrode (23) forming a rectifying junction with said first semiconductor layer is arranged between the source and drain contacts, said diode having a Schottky contact provided on a second n-type semiconductor layer (112) also formed at the surface of the substrate, characterized in that it has at least one d.c. supply conductor (1) and at least one ground conductor (3) also integrated on said substrate, in that the d.c. supply conductor is connected resistively to the second semiconductor layer (112) and in that the ground conductor forms a Schottky contact of large surface area with the second semiconductor layer thus constituting the diode thus having a high capacitance value and realizing the decoupling between the supply and the ground conductor of the integrated circuits.

2. A semiconductor device as claimed in Claim 1, characterized in that the semiconductor layers are made of a material of the III - V group.

3. A semiconductor device as claimed in Claim 2, characterized in that the semiconductor layers consist of gallium arsenide.

4. A semiconductor device as claimed in any one of Claims 1 to 3, characterized in that the first n-type layer and the second n-type layer are separated from each other by a semi-insulating zone (12).

5. A semiconductor device as claimed in any one of Claims 1 to 3, characterized in that the first n-type layer and the second n-type layer form part of the same coherent semiconductor layer (11).

6. A semiconductor device as claimed in any one of the Claims 1 to 5, characterized in that the field effect transistor has a resistive load, which is formed in a prolonged part of the first n-type layer, and in that the end contacts of this resistor are on the one hand the ohmic drain contract (22) of the transistor and on the other hand a second ohmic contact (2) also provided at the surface of this first n-type layer and connected to the supply conductor.

7. A semiconductor device as claimed in Claim 6, characterized in that the d.c. supply conductor is constituted by a metal layer at the surface of the semiinsulating zone and connected to the second semiconductor layer and to the second ohmic contact of the load resistor through a superimposed metal layer designated as second interconnection layer.

8. A semiconductor device as claimed in any one of Claims 1 to 7, characterized in that the gate electrode (23) forms a Schottky contact with the first semiconductor layer.

9. A semiconductor device as claimed in Claim 8, characterized in that the field effect transistor is of the type having a grooved channel (25).

10. A semiconductor device as claimed in any one of Claims 1 to 9, characterized in that the substrate (10) consists of semi-insulating gallium arsenide.

EP 0 204 387 B1

FIG.1

FIG.2

FIG.3

FIG.4